# FASCICULE DE BREVET EUROPEEN

(11) **EP 3 339 983 B1**
(45) Date de publication et mention de la délivrance du brevet: **01.07.2020**
(21) Numéro de dépôt: 16206568.4
(22) Date de dépôt: 23.12.2016
(51) Int. Cl.: G04B 45/00, G04B 19/12, G04D 3/00, A44C 27/00, C23C 28/04, C23C 14/00, C23C 14/02, C23C 14/06, C23C 14/24, C23C 14/34, B44C 3/02

(54) **SUBSTRAT EN NACRE REVÊTU D'UNE COUCHE JAUNE**
PERLMUTTSUBSTRAT, DAS MIT EINER GELBEN SCHICHT BESCHICHTET IST
MOTHER-OF-PEARL SUBSTRATE COATED WITH A YELLOW LAYER

(43) Date de publication de la demande: 27.06.2018
(73) Titulaire: The Swatch Group Research and Development Ltd, 2074 Marin (CH)
(72) Inventeur: SPASSOV, Vladislav, 1788 Praz (CH)
(74) Mandataire: Giraud, Eric

(56) Documents cités:
- EP-A1- 1 672 436
- EP-A2- 0 353 060
- FR-A1- 2 425 210
- JP-A- 2009 213 616
- US-A1- 2014 037 943
- JINDRICH MUSIL ET AL: "Ti-Si-N Films with a High Content of Si", PLASMA PROCESSES AND POLYMERS, vol. 4, no. S1, 1 avril 2007 (2007-04-01), pages S574-S578, XP055397274, DE ISSN: 1612-8850, DOI: 10.1002/ppap.200731408
- J. PANG ET AL: "Deposition of Ti-Si-N films on Al substrates by magnetron sputtering", SURFACE ENGINEERING., vol. 29, no. 10, 1 novembre 2013 (2013-11-01), pages 749-754, XP055397273, GB ISSN: 0267-0844, DOI: 10.1179/1743294413Y.0000000178

## Description

### Domaine de l'invention

L'invention concerne un procédé de revêtement coloré sur un composant d'horlogerie ou de bijouterie, notamment un composant d'habillage, comportant au moins une surface d'aspect préparée au préalable sur un substrat, ledit procédé comportant au moins une étape de dépôt sous vide d'au moins une couche principale de nitrure de titane et de silicium (Ti, Siₖ)Nₓ ou de nitrure de titane et de silicium dopé à l'oxygène (Ti, Siₖ)NₓO_{y} et selon la revendication 1.

L'invention concerne encore un composant de structure d'horlogerie ou de bijouterie comportant un substrat en nacre selon la revendication 15.

L'invention concerne encore un composant d'habillage d'horlogerie ou de bijouterie comportant un substrat en nacre selon la revendication 15.

La présente invention se rapporte au domaine de l'horlogerie et de la bijouterie.

### Arrière-plan de l'invention

L'aspect esthétique est très important dans les domaines de l'horlogerie et de la bijouterie, et il est apprécié de colorer certains composants. On pense en particulier aux cadrans de montre qu'on aime colorer en différentes couleurs et, entre autres, dans un coloris jaune pâle appelé ci-après « Champagne » et rappelant la couleur de certains grands vins blancs effervescents, associés à une image de luxe.

L'utilisation de couches minces inorganiques pour colorer des surfaces des pièces horlogères est bien établie et utilisée. Toutefois, la plupart des couches utilisées (métaux, nitrures, carbures, et autres) sont fortement absorbantes et pratiquement opaques déjà à partir d'une épaisseur de quelques dizaines de nanomètres. En plus, elles réfléchissent beaucoup la lumière et ont donc un aspect métallique, qui n'est pas toujours souhaité. Ces deux caractéristiques limitent fortement leur utilisation pour colorer une surface en maintenant son aspect original encore visible, par exemple un aspect nacré ou interférentiel, ou, dans le cas de l'horlogerie de luxe, une surface anglée ou encore guillochée, et devant rester brute d'usinage, sans le moindre traitement mécanique de polissage, de sablage ou similaire.

Pour arriver à ce but, il faut utiliser une couche qui, à la fois:
- absorbe très sélectivement dans le spectre visible (ceci définit la couleur en transmission de cette couche); ceci permet une "couleur intrinsèque" qui est indépendante de l'angle de vue ;
- a une réflectance la plus basse possible, comparable à des oxydes diélectriques (absence de l'aspect métallique) ;
- adhère bien au substrat ;
- est non-toxique ;
- est stable aux conditions de production et d'utilisation de l'article revêtu, par exemple lavage, montage des appliques, manipulation, et similaires ;
- est déposée sous conditions qui ne dégradent pas le substrat ;
- est stable chimiquement et résiste aux tests usuels pour habillage interne dans l'horlogerie : UV, chaleur-humide, chocs thermiques, et autres.

Ces propriétés sont souvent contradictoires, et il est difficile de satisfaire simultanément à toutes ces conditions.

Le cas particulier de la couleur jaune pâle est malcommode à traiter car souvent les couches utilisées sont peu résistantes, en particulier peu résistantes à l'abrasion. En effet, les compositions chimiques typiquement utilisées pour créer des couches minces de couleur jaune transparentes contiennent en général des oxydes de fer et sont peu résistantes à l'abrasion et aux attaques chimiques.

D'autres compositions chimiques typiquement utilisées pour créer des couches minces de couleur jaune ont un fort reflet brillant, et ne sont pas transparentes: ce sont notamment des nitrures et carbonitrures de Ti et/ou Zr, (Ti,Zr)Nₓ; (Zr,Hf)Nₓ.

S'il est imaginable de créer une couleur par interférence, par couches diélectriques, notamment SiO₂, ou Si₃N₄, cette technique possède un inconvénient chronique, qui réside dans le fait que la couleur apparente est dépendante de l'angle d'observation. De plus, pour un tel type de couches, la couleur en réflexion est toujours très forte et complémentaire à celle de transmission.

Une coloration par pigments organiques est, encore, réalisable, mais présente des défauts de stabilité à long terme des pigments, et une faible résistance à l'abrasion et aux attaques chimiques.

Et il semble qu'il n'existe à ce jour sur le marché aucune couche jaune transparente compatible avec les exigences mentionnées ci-dessus, et possédant de très bonnes propriétés de résistance à l'abrasion.

Le document FR 2 425 210 A1 Nishida Nobuo décrit des composants de bijouterie pourvus d'un revêtement de couleur or sur un substrat insensible à la chaleur, le revêtement ayant une épaisseur de 0-1 µm, constitué de nitrure de titane. comportant un élément parmi Al, Si, V, Cr, Fe, Co, Ni, Cu, Zn, Ge, Y, Zr, Nb, Mo, Ru, Rh, Pd, Ag, Cd, In, Sn, Sb, Ti, Hf, Ta, W, Ir, Pt et Au. La surface extérieure du revêtement présente un rapport de réflexion spectrale compris entre 1,2 /1-3,0 /1 à 550 m mu et 400 m mu. Le support peut être de l'acier et/ou du Ni et/ou du Ni-Ag, et/ou un alliage tel qu'un alliage de Al, et/ou une substance céramique, et/ou une résine résistant à la chaleur. Pour les boîtiers de montres, les sangles et les bagues. La couleur du revêtement ressemble étroitement à l'or et la méthode est économique.

Le document EP 0 353 060 A2 NIPPON STEEL décrit une plaque métallique dotée d'une excellente couleur décorative par un revêtement multicouche d'une couche de céramique colorée formée sur la plaque de métal, la couche de céramique colorée étant constituée d'au moins un composé choisi parmi les nitrures et les carbures de titane, zirconium, le hafnium, le chrome, le niobium et l'aluminium et ayant une épaisseur de 0,1 µm à 1 µm; et une couche de céramique transparente formée sur la couche de céramique colorée, la couche de céramique transparente étant faite d'au moins l'un du groupe consistant en oxyde de silicium, nitrure de silicium et oxyde d'aluminium et ayant une épaisseur de 0,1 µm à 5 µm. Les dépôts des couches céramiques colorées et transparentes sont effectués par un procédé à sec, et l'ordre de dépôt des couches céramiques colorées et transparentes peut être inversé.

Le document US 2014/037943 A1 Cao Da-Hua décrit un article revêtu comprenant un substrat métallique, une couche TiSiN formée directement sur le substrat métallique, la couche TiSiN consistant essentiellement élémentaire Ti, Si élémentaire, et N élémentaire, le Si élémentaire dans la couche TiSiN ayant un pourcentage en masse diminuant progressivement à partir du fond de la couche TiSiN près du substrat à la partie supérieure de la couche TiSiN éloignée du substrat, la N élémentaire ayant un pourcentage de masse en augmentant progressivement à partir du fond de la couche TiSiN près du substrat à la partie supérieure de la couche TiSiN l' écart du substrat; et une couche de TiN formée directement sur la couche TiSiN, la couche de TiN étant constituée essentiellement de Ti élémentaire et N élémentaire.

Le document JP 2009 213616 A CITIZEN décrit une couche rigide comportant une couche de nitrure comme dans l'invention, mais aussi une couche de finition comportant de l'or ou un alliage d'or, sous une couche superficielle transparente.

Le document EP 1 672 436 A1 ROLEX décrit un procédé de fabrication d'un cadran pour pièce d'horlogerie dont la surface visible comporte un revêtement d'aspect métallique dont l'état de surface présente une morphologie caractéristique de celle de la nacre, caractérisé en ce que l'on soumet une plaque de nacre à une opération de sablage pour lui donner un état de surface correspondant à la morphologie de cette nacre, on nettoie cette surface et on la revêt d'une couche métallique ou d'oxyde, nitrure ou carbure métallique.

L'article de Jindrich Musil et al., publié le 01.04.2007, concerne « Ti-Si-N films with a high content of Si », Plasma proccesses and polymers, vol. 4, N°S1, pages S574-578, XP055397274, ISSN 1612-8850, DOI 10.2012/ppap.200731408.

L'article de J. Pang & al., publié le 01.11.2013, concerne « déposition of Ti-Si-N films on Al substrates by magnetron sputtering », Surface engineering, vol.29, N°10, pages 749-754, XP055397272, ISSN 0267-0844, DOI 10.1179/1743294413Y.0000000178.

### Résumé de l'invention

L'invention se propose de donner un aspect jaune « Champagne » à des composants de structure ou d'habillage d'horlogerie ou de bijouterie, notamment des composants en nacre tels que des cadrans ou similaires, en gardant visible la surface originale de ces pièces.

A cet effet, l'invention concerne un procédé de revêtement coloré sur un composant de structure ou un composant d'habillage d'horlogerie ou de bijouterie, selon la revendication 1.

L'invention concerne encore un composant de structure d'horlogerie ou de bijouterie comportant un substrat en nacre.

L'invention concerne encore un composant d'habillage d'horlogerie ou de bijouterie comportant un substrat en nacre.

Selon l'invention, la coloration est faite par au moins une couche principale intrinsèquement jaune en transmission et transparente, non-opaque. Cette coloration est basée sur du nitrure de titane et de silicium (Ti, Siₖ)Nₓ ou du nitrure de titane et de silicium dopé à l'oxygène (Ti, Siₖ)NₓO_{y} qui, grâce à sa transparence, n'occulte pas les effets visuels propres à la surface au-dessous du revêtement, qui peuvent notamment provenir d'opérations de brossage, guillochage, ou autres, aptes à produire un effet particulier de relief, ou un aspect nacré, ou des effets interférentiels, ou autre.

La couche est déposée sous vide, par exemple, par Physical Vapor Déposition en utilisant la pulvérisation cathodique (sputter-PVD) ou ionique (ion-beam-PVD), évaporation (evaporation-PVD), ablation par laser (Pulsed Laser Déposition PVD), ou autre procédé similaire.

Ce nouveau procédé de coloration est particulièrement bien adapté pour un substrat en nacre.

Ce procédé permet le dépôt d'une couche jaune, qui est transparente, et plus particulièrement à reflets dorés, tout en ayant un pouvoir colorant suffisant en couche mince.

La couche de la base de nitrure de titane et de silicium (Ti, Siₖ)Nₓ ou de nitrure de titane et de silicium dopé à l'oxygène (Ti, Siₖ)NₓO_{y} selon l'invention est très résistante à l'abrasion et aux attaques chimiques, et est biocompatible. Ces propriétés rendent cette couche compatible avec les exigences d'habillage externe.

### Description sommaire des dessins

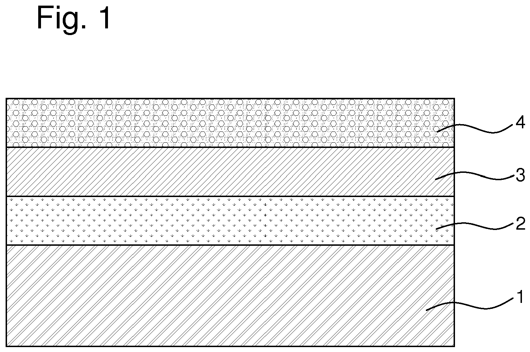

D'autres caractéristiques et avantages de l'invention apparaîtront à la lecture de la description détaillée qui va suivre, en référence aux dessins annexés, où la figure 1 représente, de façon schématisée, et en coupe, un composant d'habillage d'horlogerie ou de bijouterie réalisé par un procédé similaire mais différent de celui protégé par le brevet, comportant un empilement de différentes couches sur le substrat, dont une couche de nitrure de titane et de silicium (Ti, Siₖ)Nₓ ou de nitrure de titane et de silicium dopé à l'oxygène (Ti, Siₖ)NₓO_{y}.

### Description détaillée des modes de réalisation préférés

L'invention concerne un procédé de revêtement coloré sur un composant de structure ou un composant d'habillage d'horlogerie ou de bijouterie comportant au moins une surface d'aspect préparée au préalable sur un substrat 1.

Par composant de structure on entend un composant fonctionnel, remplissant une fonction mécanique tel que platine, pont, rouage, maillon, fermoir, ou similaire.

Par composant d'habillage on entend un composant dont la fonction est davantage visuelle, en particulier un composant d'affichage tel qu'un cadran, une lune, ou autre, ou un composant d'aspect sur un bracelet ou un bijou.

On comprend que, si le procédé selon l'invention est applicable à tout composant horloger ou de bijouterie choisi dans un matériau compatible, il trouve une application préférentielle mais non limitative à certains types de composants tels que des cadrans ou similaires.

Plus particulièrement, ce procédé est applicable au revêtement d'un composant en nacre.

Selon l'invention, ce procédé comporte au moins une étape de dépôt sous vide d'au moins une couche principale 3 de nitrure de titane et de silicium (Ti, Siₖ)Nₓ ou de nitrure de titane et de silicium dopé à l'oxygène (Ti, Siₖ)NₓO_{y}.

Ainsi la coloration est réalisée par dépôt d'au moins une couche principale 3, intrinsèquement jaune en transmission et transparente. Selon l'invention, cette couche principale 3 est composée d'un nitrure de titane et de silicium (Ti, Siₖ)Nₓ ou d'un nitrure de titane et de silicium dopé à l'oxygène (Ti, Siₖ)NₓO_{y}, avec ou sans dopage par d'autres métaux, qui, grâce à sa transparence, ne supprime pas les effets visuels de la surface en dessous. Cette couche principale 3 ajoute un aspect jaune aux couleurs originelles des surfaces du substrat 1, en fonction de la préparation de ce substrat 1 de base : structuration, anglage, striage, guillochage, ou autre.

Il est possible de combiner des reflets irisés du substrat 1, notamment quand il est en nacre, des reflets d'une texture y compris un brossage ou un polissage, ou encore d'effets interférentiels induits par le dépôt de couches additionnelles intermédiaires 2 entre le substrat 1 et la couche principale 3 jaune.

On notera que la couche principale 3 jaune peut, aussi, venir directement en revêtement du substrat 1.

Les couches principales 3 minces qui donnent un aspect jaune suffisamment saturé se trouvent dans une gamme d'épaisseur de 20 nm à 2000 nm, et sont déposées sur le substrat sans ou avec une couche d'accrochage.

Dans une réalisation particulière non limitative, les couches principales 3 se présentent comme un empilement dans lequel le nitrure de titane et de silicium (Ti, Siₖ)Nₓ ou le nitrure de titane et de silicium dopé à l'oxygène (Ti, Siₖ)NₓO_{y}, peut être dans une forme pure ou dopée avec d'autres composants.

Dans une autre réalisation particulière non limitative, le nitrure de titane et de silicium (Ti, Siₖ) Nₓ ou le nitrure de titane et de silicium dopé à l'oxygène (Ti, Siₖ)NₓO_{y}, constitue une couche monolithique.

Une ou plusieurs couches additionnelles, intermédiaires 2 ou supérieures 4, diélectriques, transparentes ou semi-transparentes, peuvent être déposées sous ou sur la couche principale 3 de nitrure de titane-silicium ou de nitrure de titane-silicium dopé à l'oxygène, pour ajustement de la couleur en réflexion et/ou transmission par des effets interférentiels.

Dans un mode de réalisation particulier, on recherche l'optimisation de l'épaisseur de la couche, afin de profiter de la couleur interférentielle en plus de la couleur intrinsèque de la couche.

Dans un autre mode de réalisation particulier, on ajoute d'autres couches additionnelles intermédiaires 2 ou supérieures 4 transparentes afin de :
- augmenter la résistance chimique et mécanique ;
- améliorer l'adhésion de l'empilement sur le substrat ou de la couche colorée ;
- optimiser davantage la couleur par interférence ;
- donner un aspect brillant ou mat, selon ce qui est recherché ;
- donner un aspect de profondeur.

Plus particulièrement, les proportions avantageuses, qui donnent des bons résultats sont dans la gamme de rapport k=Si/Ti compris de 1.5 à 4.0, donc les compositions de type (TiSi_{1.5})Nₓ jusqu'à (TiSi₄)Nₓ, ou encore (Ti, Si_{1.5})NₓO_{y} jusqu'à (Ti, Si₄)NₓO_{y}.

La valeur de x ou y dans les formules n'est pas mesurée. Les couches principales 3 n'ont aucun aspect métallique, donc on peut conclure qu'ils sont très proches de la stœchiométrie au niveau d'azote. Il s'agit de couches principales « quasi-stœchiométriques ».

Pour les proportions extrêmes de silicium par rapport au titane, dans la plage convenable, on peut calculer les valeurs x pour des couches principales 100% stœchiométriques :
- pour (Ti, Si_{1.5})Nₓ, la valeur maximum de x= 3.00
- pour (Ti, Si₄)Nₓ, la valeur maximum de x= 6.33

On peut ainsi définir une plage des valeurs de x = 3.00 à 6.33.

La teinte et la saturation de la couleur sont fonction du rapport k= Si/Ti et de l'épaisseur de la couche. Pour obtenir la couleur jaune, le rapport k= Si/Ti est sélectionné avec une valeur comprise entre 1.5 et 4.0.

L'épaisseur est choisie entre 20 nm et 2000 nm pour que la couleur jaune de la couche soit suffisamment saturée. Eventuellement, le nitrure de titane et de silicium (Ti, Siₖ)Nₓ, ou le nitrure de titane et de silicium dopé à l'oxygène (Ti, Siₖ)NₓO_{y}, peut être dopé avec d'autres métaux, par exemple avec du lithium, pour augmenter la saturation de la couleur.

La couche principale 3 de nitrure de titane et de silicium (Ti, Siₖ)Nₓ, ou de nitrure de titane et de silicium dopé à l'oxygène (Ti, Siₖ)NₓO_{y} peut être déposée sous vide par dépôt physique en phase vapeur (PVD) en utilisant une des techniques regroupées sous le terme générique PVD, à savoir la pulvérisation cathodique, la pulvérisation par faisceau d'ions, l'évaporation ou l'ablation laser.

Parmi la plage utile de 20 nm à 2000 nm, les épaisseurs de couches optimales sont dans la gamme de 100 nm à 300 nm, en fonction de l'intensité de la couleur souhaitée : la couleur est d'autant plus profonde que la couche est épaisse.

Parmi les dopages, un dopage à l'oxygène procure de bons résultats, malgré un préjugé selon lequel on ne l'utilise pas dans les couches prévues pour la nacre, sa formulation chimique adéquate est de type :
(Ti, Siₘ)NₓO_{y}, où m = 1.5 à 4 et x>y

En théorie on peut substituer tous les atomes d'azote avec des atomes d'oxygène. A partir d'une certaine concentration d'oxygène, on va perdre l'absorption fortement sélective (donc perte de la coloration utile de la couche), ce qui amène à limiter la valeur du coefficient y, de préférence compris entre y = 0 et y= 2.

Une couche d'accrochage est facultative, et, dans le cas particulier d'un revêtement sur de la nacre aucune couche d'accroche ne s'avère nécessaire. Selon la nature du substrat 1, pour les cas où on désire une couche d'accrochage afin d'améliorer l'accroche de la couche principale 3 sur le substrat 1, le dépôt sous vide d'une couche principale 3 de nitrure de titane et de silicium (Ti, Siₖ)Nₓ ou de nitrure de titane et de silicium dopé à l'oxygène (Ti, Siₖ)NₓO_{y} peut être précédé d'un traitement plasma, ou plus particulièrement d'un traitement plasma sous argon et/ou oxygène, notamment sous argon pur ou sous oxygène pur.

En outre et toujours optionnellement, des couches additionnelles intermédiaires 2 ou supérieures 4, transparentes ou semi-transparentes, peuvent être déposées au-dessus et/ou en dessous de la couche principale de nitrure de titane et de silicium (Ti, Siₖ)Nₓ ou de nitrure de titane et de silicium dopé à l'oxygène (Ti, Siₖ)NₓO_{y}.

Un cumul de couches résulte davantage du mode d'élaboration que d'un choix délibéré.

Dans une séquence particulière du procédé selon l'invention, on effectue une pulvérisation cathodique (préférablement), ou par faisceau ionique, des cibles métalliques de Ti et Si (mais aussi possible avec une cible d'alliage Ti/Si avec les proportions souhaitées), en ajoutant des gazes réactifs (« pulvérisation réactive »).

D'autres modes de mise en œuvre sont possibles :
- pulvérisation cathodique, ou par faisceau ionique, d'une cible céramique à la base de (Ti, Siₖ)NₓO_{y} ;
- évaporation sous vide par faisceau d'électrons, par arc électrique ou par effet Joule d'un alliage de Ti et Si (préférablement TiSi₂) en ajoutant des gazes réactifs (« évaporation réactive »).

Le substrat 1 peut, outre la couche principale 3 de nitrure de titane et de silicium (Ti, Siₖ)Nₓ ou de nitrure de titane et de silicium dopé à l'oxygène (Ti, Siₖ)NₓO_{y}, porter au moins une couche additionnelle 2 intermédiaire. Cette couche additionnelle intermédiaire 2 peut avoir plusieurs fonctions. Elle peut être utilisée pour promouvoir l'accroche de la couche principale 3 de nitrure de titane et de silicium (Ti, Siₖ)Nₓ ou de nitrure de titane et de silicium dopé à l'oxygène (Ti, Siₖ)NₓO_{y} sur le substrat 1. Une autre fonction peut être d'ajuster la couleur en réflexion par effet interférentiel. A cet effet, la couche additionnelle intermédiaire 2 peut être monocouche ou formée d'un empilement de couches avec alternance de couches à bas et haut indice de réfraction afin d'obtenir l'effet interférentiel souhaité, une ou plusieurs de ces couches pouvant être absorbante.

A titre d'exemple on peut notamment utiliser un empilement de couches de SiO₂ : indice de 1.46 (bas) et de couche de Si₃N₄ : indice de 2 (haut). On choisit de préférence des épaisseurs de couches pour chacune d'elle entre 10nm et 400 nm. L'indice de réfraction et l'épaisseur des couches permettent de contrôler le phénomène d'interférence, à savoir l'amplitude et la longueur d'onde de l'interférence constructive et/ou destructive.

On notera que la couche principale 3 de nitrure de titane et de silicium (Ti, Siₖ)Nₓ ou de nitrure de titane et de silicium dopé à l'oxygène (Ti, Siₖ)NₓO_{y} participe de la même manière dans l'empilement que les autres couches, selon les mêmes lois d'interférence. La couche principale 3 de nitrure de titane et de silicium (Ti, Siₖ)Nₓ ou de nitrure de titane et de silicium dopé à l'oxygène (Ti, Siₖ)NₓO_{y} peut donc être utilisée comme une partie de ces empilements pour créer des effets interférentiels additionnels. Autrement dit, on peut créer (en utilisant des logiciels de simulation optique) des empilements avec le nitrure de titane et de silicium (Ti, Siₖ)Nₓ ou le nitrure de titane et de silicium dopé à l'oxygène (Ti, Siₖ)NₓO_{y} et des couches d'indice de réfraction bas et haut, qui permettent des propriétés optiques inatteignables en utilisant uniquement une couche de nitrure de titane et de silicium (Ti, Siₖ)Nₓ ou de nitrure de titane et de silicium dopé à l'oxygène (Ti, Siₖ)NₓO_{y}.

Plus particulièrement, les matériaux de la couche additionnelle intermédiaire 2 sont choisis parmi les nitrures, oxynitrures, et/ou les oxydes de silicium et/ou métalliques et notamment parmi les métaux suivants : Ti, Al, Ta, Ce, Zr, Hf.

Le revêtement peut en outre comporter au moins une couche additionnelle supérieure 4, c'est-à-dire une couche déposée sur la surface libre, à l'opposé du substrat 1, de la couche principale 3 de nitrure de titane et de silicium (Ti, Siₖ)Nₓ ou de nitrure de titane et de silicium dopé à l'oxygène (Ti, Siₖ)NₓO_{y}. Cette couche additionnelle supérieure 4 peut également remplir une ou plusieurs fonctions. Elle peut avoir pour fonction d'augmenter la résistance mécanique et chimique du revêtement, de donner un aspect brillant ou mat au revêtement et/ou de donner un effet de profondeur. Comme pour la couche additionnelle intermédiaire 2, elle peut aussi avoir pour fonction d'ajuster la couleur par effet interférentiel. Elle peut être monocouche ou multicouche (empilement de couches alternées de SiO₂ et Si₃N₄) comme décrit pour la couche additionnelle intermédiaire 2 et, de même, être formée de nitrures et/ou d'oxydes de divers matériaux.

Plus particulièrement, la couche additionnelle intermédiaire 2 et la couche additionnelle supérieure 4 éventuelles ont chacune une épaisseur comprise entre 20 et 2000 nm, l'épaisseur étant celle de la monocouche si une seule couche est déposée ou du multicouche dans le cas contraire.

Il se pose encore, en horlogerie et en bijouterie, le problème de la tenue de la couleur dans des environnements chauds et humides. Pour résoudre ce problème, il est proposé un empilement de couches, en particulier d'Al₂O₃ et de nitrure de titane et de silicium (Ti, Siₖ)Nₓ ou de nitrure de titane et de silicium dopé à l'oxygène (Ti, Siₖ)NₓO_{y} avec des épaisseurs déterminées, empilement qui résisterait à la décoloration dans ces environnements hostiles. Ainsi, pour protéger le composant de la décoloration en milieu chaud ou/et humide, la couche additionnelle intermédiaire 2, ou supérieure 4, comporte un empilement de couches d'alumine Al₂O₃ en alternance avec au moins une couche principale 3 de nitrure de titane et de silicium (Ti, Siₖ)Nₓ ou de nitrure de titane et de silicium dopé à l'oxygène (Ti, Siₖ)NₓO_{y}.

Une application particulière et avantageuse de ce procédé concerne le cas d'un tel composant dont le substrat 1 est en nacre.

L'invention concerne encore un composant d'habillage ou de structure d'horlogerie ou de bijouterie comportant un substrat en nacre et selon la revendication 15. Ce composant comporte au moins une surface d'un revêtement jaune au-dessus de ce substrat 1, et ce revêtement comporte au moins une couche principale 3 de nitrure de titane et de silicium (Ti, Siₖ)Nₓ ou de nitrure de titane et de silicium dopé à l'oxygène (Ti, Siₖ)NₓO_{y}, de préférence selon l'une des formulations exposées plus haut.

Plus particulièrement, ce substrat 1 est un cadran.

En somme, la couche jaune déposée sur le substrat en nacre selon l'invention présente plusieurs avantages :
- la couleur est jaune indépendamment de l'angle de vue. Il est possible de moduler la teinte et l'intensité de cette couleur en déposant des couches interférentielles et en ajustant l'épaisseur de la couche de nitrure de titane et de silicium (Ti, Siₖ)Nₓ ou de nitrure de titane et de silicium dopé à l'oxygène (Ti, Siₖ)NₓO_{y} ou sa composition.
- la morphologie particulière de la nacre est toujours visible après dépôt.
- la couche adhère bien au substrat, l'adhérence pouvant encore être améliorée grâce au traitement plasma et au dépôt de couches interférentielles.
- la réflectance est basse, comparable à celle des oxydes diélectriques, pour éviter l'aspect métallique.
- le revêtement est non toxique.
- le revêtement est stable aux conditions de production et d'utilisation de l'article revêtu (lavage, montage des appliques, manipulation, etc.).
- le revêtement est déposé sous conditions qui ne dégradent pas le substrat.
- le revêtement est stable chimiquement et résiste aux tests usuels pour l'habillage interne dans l'horlogerie (UV, chaleur humide, chocs thermiques).

En conclusion, l'invention à la base de nitrure de titane et de silicium (Ti, Siₖ)Nₓ ou de nitrure de titane et de silicium dopé à l'oxygène (Ti, Siₖ)NₓO_{y} met en œuvre une couche, de coloris jaune, en nuance dite « Champagne », plus particulièrement à reflets dorés, cette couche est très résistante, en particulier à l'abrasion, et est supérieure à tous les revêtements connus de l'art antérieur dans ce coloris. Cette couche possède de bonnes propriétés de transparence, et se révèle appropriée aux réalisations de haute horlogerie ou de joaillerie, pour protéger et mettre en valeur les composants concernés.

## Revendications

1. Procédé de revêtement coloré sur un composant de structure ou un composant d'habillage d'horlogerie ou de bijouterie comportant au moins une surface d'aspect préparée au préalable sur un substrat (1), ledit procédé comportant au moins une étape de dépôt sous vide d'au moins une couche principale (3) de nitrure de titane et de silicium (Ti, Siₖ)Nₓ ou de nitrure de titane et de silicium dopé à l'oxygène (Ti, Siₖ)NₓO_{y}, **caractérisé en ce qu'**une couche additionnelle intermédiaire (2) et/ou une couche additionnelle supérieure (4), transparente ou semi-transparente, est déposée entre le substrat (1) et la couche principale (3) de nitrure de titane et de silicium (Ti, Siₖ)Nₓ ou de nitrure de titane et de silicium dopé à l'oxygène (Ti, Siₖ)NₓO_{y} et/ou sur la surface libre de la couche principale (3) de nitrure de titane et de silicium (Ti, Siₖ)Nₓ ou de nitrure de titane et de silicium dopé à l'oxygène (Ti, Siₖ)NₓO_{y} , et **en ce que**, pour protéger ledit composant de la décoloration en milieu chaud ou/et humide, ladite couche additionnelle (2,4) comporte un empilement de couches d'alumine Al₂O₃ en alternance avec au moins une couche principale de nitrure de titane et de silicium (Ti, Siₖ)Nₓ ou de nitrure de titane et de silicium dopé à l'oxygène (Ti, Siₖ)NₓO_{y}.

2. Procédé selon la revendication 1, dans lequel ledit nitrure de titane et de silicium (Ti, Siₖ)Nₓ ou ledit nitrure de titane et de silicium dopé à l'oxygène (Ti, Siₖ)NₓO_{y} a un coefficient k (rapport Si/Ti) compris entre 1.5 et 4.0, pour donner une couleur jaune à ladite couche principale (3).

3. Procédé selon la revendication 1 ou 2, **caractérisé en ce que** ladite au moins une couche principale (3) de nitrure de titane et de silicium (Ti, Siₖ)Nₓ ou de nitrure de titane et de silicium dopé à l'oxygène (Ti, Siₖ)NₓO_{y} a une épaisseur comprise entre 20 nm et 2000 nm.

4. Procédé selon la revendication 3, **caractérisé en ce que** ladite au moins une couche principale (3) de nitrure de titane et de silicium (Ti, Siₖ)Nₓ ou de nitrure de titane et de silicium dopé à l'oxygène (Ti, Siₖ)NₓO_{y} a une épaisseur comprise entre 30 nm et 300 nm.

5. Procédé selon l'une des revendications 1 à 4, **caractérisé en ce que** ladite au moins une couche principale (3) de nitrure de titane et de silicium (Ti, Siₖ)Nₓ ou de nitrure de titane et de silicium dopé à l'oxygène (Ti, Siₖ)NₓO_{y} a un coefficient x compris entre 3.00 et 6.33.

6. Procédé selon l'une des revendications 1 à 5, **caractérisé en ce que** ladite au moins une couche principale (3) est une couche principale (3) de nitrure de titane et de silicium dopé à l'oxygène (Ti, Siₖ)NₓO_{y}, et **en ce que** le coefficient y est compris entre 0.0 et 2.0.

7. Procédé selon l'une des revendications 1 à 6, **caractérisé en ce que** ledit nitrure de titane et de silicium (Ti, Siₖ)Nₓ ou ledit nitrure de titane et de silicium dopé à l'oxygène (Ti, Siₖ)NₓO_{y} est encore dopé au lithium pour saturer la couleur.

8. Procédé selon l'une des revendications 1 à 7, **caractérisé en ce que** le dépôt sous vide d'une couche principale (3) de nitrure de titane et de silicium (Ti, Siₖ)Nₓ ou de nitrure de titane et de silicium dopé à l'oxygène (Ti, Siₖ)NₓO_{y} est précédé d'un traitement plasma afin d'améliorer l'accroche de ladite couche principale (3) sur le substrat (1).

9. Procédé selon la revendication 8, **caractérisé en ce que** le dépôt sous vide d'une couche principale (3) de nitrure de titane et de silicium (Ti, Siₖ)Nₓ ou de nitrure de titane et de silicium dopé à l'oxygène (Ti, Siₖ)NₓO_{y} est précédé d'un traitement plasma sous argon et/ou oxygène afin d'améliorer l'accroche de ladite couche principale (3) sur le substrat (1).

10. Procédé selon l'une des revendications 1 à 9, **caractérisé en ce que** ladite couche additionnelle intermédiaire (2) et/ou ladite couche additionnelle supérieure (4) est formée d'une seule couche ou d'un empilement de couches.

11. Procédé selon la revendication 10, dans lequel ladite couche additionnelle (2,4) est formée d'un empilement de couches avec alternance d'une couche avec un indice de réfraction donné et d'une couche ayant un indice de réfraction supérieur à l'indice donné pour créer un effet interférentiel.

12. Procédé selon l'une des revendications 1 à 11, **caractérisé en ce que** ladite couche additionnelle (2,4) est composée de nitrures, oxynitrures et/ou d'oxydes métalliques ou de silicium.

13. Procédé selon la revendication 12, dans lequel les métaux des oxydes et nitrures sont sélectionnés parmi la liste constituée du titane, du tantale, de l'aluminium, du zirconium, de hafnium et du cérium.

14. Procédé selon l'une des revendications 1 à 13, **caractérisé en ce qu'**on l'applique à un dit composant dont ledit substrat (1) est en nacre.

15. Composant de structure ou d'habillage d'horlogerie ou de bijouterie comportant un substrat (1) en nacre, **caractérisé en ce que** ledit composant comporte au moins une surface d'un revêtement jaune au-dessus dudit substrat (1) et qui comporte au moins une couche principale (3) de nitrure de titane et de silicium (Ti, Siₖ)Nₓ ou de nitrure de titane et de silicium dopé à l'oxygène (Ti, Siₖ)NₓO_{y}, et encore **caractérisé en ce que** ledit composant comporte une couche additionnelle intermédiaire (2) et/ou une couche additionnelle supérieure (4), transparente ou semi-transparente, entre le substrat (1) et la couche principale (3) de nitrure de titane et de silicium (Ti, Siₖ)Nₓ ou de nitrure de titane et de silicium dopé à l'oxygène (Ti, Siₖ)NₓO_{y} et/ou sur la surface libre de la couche principale (3) de nitrure de titane et de silicium (Ti, Siₖ)Nₓ ou de nitrure de titane et de silicium dopé à l'oxygène (Ti, Siₖ)NₓO_{y} , et **en ce que**, pour protéger ledit composant de la décoloration en milieu chaud ou/et humide, ladite couche additionnelle (2,4) comporte un empilement de couches d'alumine Al₂O₃ en alternance avec au moins une couche principale de nitrure de titane et de silicium (Ti, Siₖ)Nₓ ou de nitrure de titane et de silicium dopé à l'oxygène (Ti, Siₖ)NₓO_{y}.

16. Composant d'habillage d'horlogerie ou de bijouterie selon la revendication 15, **caractérisé en ce que** ledit substrat (1) est un cadran.

## Patentansprüche

1. Verfahren zum Aufbringen eines Farbüberzuges auf eine Struktur- oder Ausstattungskomponente von Uhren oder Schmuck, umfassend mindestens eine vorab auf einem Substrat (1) bearbeitete Bildfläche, wobei das Verfahren mindestens einen Schritt des Abscheidens unter Vakuum mindestens einer Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} umfasst, **dadurch gekennzeichnet, dass** zwischen dem Substrat (1) und der Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} und/oder auf der freien Oberfläche der Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} eine zusätzliche Zwischenschicht (2) und/oder eine zusätzliche obere Schicht (4), die transparent oder halbtransparent ist, abgelagert wird und dass zum Schutz der Komponente vor Entfärbung in einem heißen und/oder feuchten Milieu die zusätzliche Schicht (2, 4) eine Aufstapelung an Aluminiumoxidschichten Al₂O₃ im Wechsel mit mindestens einer Hauptschicht aus Titan- und Siliciumnitrid (Ti, Siₖ)Nₓ oder aus mit Sauerstoff dotiertem Titan- und Siliciumnitrid (Ti, Siₖ)NₓO_{y} umfasst.

2. Verfahren nach Anspruch 1, wobei das Titan- und Siliciumnitrid (Ti, Siₖ)Nₓ oder das mit Sauerstoff dotierte Titan- und Siliciumnitrid (Ti, Siₖ)NₓO_{y} einen Koeffizienten k (Verhältnis Si/Ti) im Bereich von 1,5 bis 4,0 besitzt, um der Hauptschicht (3) eine gelbe Farbe zu verleihen.

3. Verfahren nach Anspruch 1 oder 2, **dadurch gekennzeichnet, dass** die mindestens eine Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} eine Dicke im Bereich von 20 nm bis 2000 nm aufweist.

4. Verfahren nach Anspruch 3, **dadurch gekennzeichnet, dass** die mindestens eine Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} eine Dicke im Bereich von 30 nm bis 300 nm aufweist.

5. Verfahren nach einem der Ansprüche 1 bis 4, **dadurch gekennzeichnet, dass** die mindestens eine Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} einen Koeffizienten x im Bereich von 3,00 bis 6,33 aufweist.

6. Verfahren nach einem der Ansprüche 1 bis 5, **dadurch gekennzeichnet, dass** die mindestens eine Hauptschicht (3) eine Hauptschicht (3) aus mit Sauerstoff dotiertem Titan- und Siliciumnitrid (Ti, Siₖ)NₓO_{y} ist und dass der Koeffizient y dann im Bereich von 0,0 bis 2,0 liegt.

7. Verfahren nach einem der Ansprüche 1 bis 6, **dadurch gekennzeichnet, dass** das Titan- und Siliciumnitrid (Ti, Siₖ)Nₓ oder das mit Sauerstoff dotierte Titan- und Siliciumnitrid (Ti, Siₖ)NₓO_{y} ferner mit Lithium dotiert ist, um die Farbe zu sättigen.

8. Verfahren nach einem der Ansprüche 1 bis 7, **dadurch gekennzeichnet, dass** dem Abscheiden unter Vakuum einer Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} eine Plasmabearbeitung vorhergeht, um die Haftung der Hauptschicht (3) auf dem Substrat (1) zu verbessern.

9. Verfahren nach Anspruch 8, **dadurch gekennzeichnet, dass** dem Abscheiden unter Vakuum einer Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} eine Plasmabearbeitung unter Argon und/oder Sauerstoff vorhergeht, um die Haftung der Hauptschicht (3) auf dem Substrat (1) zu verbessern.

10. Verfahren nach einem der Ansprüche 1 bis 9, **dadurch gekennzeichnet, dass** die zusätzliche Zwischenschicht (2) und/oder die zusätzliche obere Schicht (4) aus einer einzigen Schicht oder aus einem Schichtstapel gebildet sind.

11. Verfahren nach Anspruch 10, wobei die zusätzliche Schicht (2, 4) aus einem Stapel von Schichten aus abwechselnd einer Schicht mit einem bestimmten Brechungsindex und einer Schicht mit einem höheren Brechungsindex als der bestimmte Index gebildet ist, um eine Interferenzwirkung zu erzeugen.

12. Verfahren nach einem der Ansprüche 1 bis 11, **dadurch gekennzeichnet, dass** die zusätzliche Schicht (2, 4) aus Nitriden, Oxynitriden und/oder Metall- oder Siliciumoxiden zusammengesetzt ist.

13. Verfahren nach Anspruch 12, wobei die Metalle der Oxide und Nitride aus der Liste ausgewählt sind, die aus Titan, Tantal, Aluminium, Zirkonium, Hafnium und Cerium gebildet ist.

14. Verfahren nach einem der Ansprüche 1 bis 13, **dadurch gekennzeichnet, dass** es auf eine Komponente angewendet wird, deren Substrat (1) aus Perlmutt hergestellt ist.

15. Struktur- oder Ausstattungskomponente von Uhren oder Schmuck, umfassend ein Substrat (1) aus Perlmutt, **dadurch gekennzeichnet, dass** die Komponente auf dem Substrat (1) mindestens eine Oberfläche einer gelben Beschichtung umfasst, die mindestens eine Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} aufweist, und ferner **dadurch gekennzeichnet, dass** die Komponente zwischen dem Substrat (1) und der Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} und/oder auf der freien Oberfläche der Hauptschicht (3) aus Titan- und Siliciumnitrid (Ti, Siₖ)Nₓ oder aus mit Sauerstoff dotiertem Titan- und Siliciumnitrid (Ti, Siₖ)NₓO_{y} eine zusätzliche Zwischenschicht (2) und/oder eine zusätzliche obere Schicht (4), die transparent oder halbtransparent ist, aufweist und dass zum Schutz der Komponente vor Entfärbung in einem heißen und/oder feuchten Milieu die zusätzliche Schicht (2, 4) einen Stapel aus Aluminiumoxidschichten Al₂O₃, im Wechsel mit mindestens einer Hauptschicht aus Titan- und Siliciumnitrid (Ti, Siₖ)Nₓ oder aus mit Sauerstoff dotiertem Titan- und Siliciumnitrid (Ti, Siₖ)NₓO_{y} umfasst.

16. Ausstattungskomponente von Uhren oder Schmuck nach Anspruch 15, **dadurch gekennzeichnet, dass** das Substrat (1) ein Zifferblatt ist.

## Claims

1. Method for coloured coating on a structural component or a watchmaking or jewellery casing part component, comprising at least one visible surface prepared in advance on a substrate (1), said method comprising at least one vacuum-deposition step of at least one main layer (3) of titanium and silicon nitride (Ti, Siₖ)Nₓ or of titanium and silicon nitride doped with oxygen (Ti, Siₖ)NₓO_{y}, **characterised in that** an additional intermediate layer (2) and/or an additional upper layer (4), transparent or semi-transparent, is deposited between the substrate (1) and the main layer (3) of titanium and silicon nitride (Ti, Siₖ)Nₓ or of titanium and silicon nitride doped with oxygen (Ti, Siₖ)NₓO_{y}, and/or on the free surface of the main layer (3) of titanium and silicon nitride (Ti, Siₖ)Nₓ or of titanium and silicon nitride doped with oxygen (Ti, Siₖ)NₓO_{y}, and **in that**, in order to protect said component from discolouration in a warm or/and humid environment, said additional layer (2, 4) comprises a stack of alumina Al₂O₃ layers alternating with at least one main layer of titanium and silicon nitride (Ti, Siₖ)Nₓ or of titanium and silicon nitride doped with oxygen (Ti, Siₖ)NₓO_{y}.

2. Method according to claim 1, in which said titanium and silicon nitride (Ti, Siₖ)Nₓ or said titanium and silicon nitride doped with oxygen (Ti, Siₖ)NₓO_{y} has a coefficient k (ratio Si/Ti) between 1.5 and 4.0 in order to give a yellow colour to said main layer (3).

3. Method according to claim 1 or 2, **characterised in that** said at least one main layer (3) of titanium and silicon nitride (Ti, Siₖ)Nₓ or of titanium and silicon nitride doped with oxygen (Ti, Siₖ)NₓO_{y} has a thickness between 20 nm and 2,000 nm.

4. Method according to claim 3, **characterised in that** said at least one main layer (3) of titanium and silicon nitride (Ti, Siₖ)Nₓ or of titanium and silicon nitride doped with oxygen (Ti, Siₖ)NₓO_{y} has a thickness between 30 nm and 300 nm.

5. Method according to one of claims 1 to 4, **characterised in that** said at least one main layer (3) of titanium and silicon nitride (Ti, Siₖ)Nₓ or of titanium and silicon nitride doped with oxygen (Ti, Siₖ)NₓO_{y} has a coefficient x between 3.00 and 6.33.

6. Method according to one of claims 1 to 5, **characterised in that** said at least one main layer (3) is a main layer (3) of titanium and silicon nitride doped with oxygen (Ti, Siₖ)NₓO_{y}, and **in that** the coefficient y is between 0.0 and 2.0.

7. Method according to one of claims 1 to 6, **characterised in that** said titanium and silicon nitride (Ti, Siₖ)Nₓ or said titanium and silicon nitride doped with oxygen (Ti, Siₖ)NₓO_{y} is also doped with lithium in order to saturate the colour.

8. Method according to one of claims 1 to 7, **characterised in that** the vacuum-deposition of a main layer (3) of titanium and silicon nitride (Ti, Siₖ)Nₓ or of titanium and silicon nitride doped with oxygen (Ti, Siₖ)NₓO_{y} is preceded by a plasma treatment in order to improve the bonding of said main layer (3) on the substrate (1).

9. Method according to claim 8, **characterised in that** the vacuum-deposition of a main layer (3) of titanium and silicon nitride (Ti, Siₖ)Nₓ or of titanium and silicon nitride doped with oxygen (Ti, Siₖ)NₓO_{y} is preceded by a plasma treatment under argon and/or oxygen in order to improve the bonding of said main layer (3) on the substrate (1).

10. Method according to one of claims 1 to 9, **characterised in that** said additional intermediate layer (2) and/or said additional upper layer (4) is formed from a single layer or from a stack of layers.

11. Method according to claim 10, in which said additional layer (2, 4) is formed from a stack of layers with alternation of a layer with a given refractive index and of a layer having a refractive index greater than the given index in order to create an interferential effect.

12. Method according to one of claims 1 to 11, **characterised in that** said additional layer (2, 4) is composed of metal or silicon nitrides, oxynitrides and/or oxides.

13. Method according to claim 12, in which the metals of the oxides and nitrides are selected from the list comprising titanium, tantalum, aluminium, zirconium, hafnium and cerium.

14. Method according to one of claims 1 to 13, **characterised in that** it is applied to a said component, the substrate (1) of which is made of mother-of-pearl.

15. Watchmaking or jewellery structural or casing part component comprising a mother-of-pearl substrate (1), **characterised in that** said component has at least one surface with a yellow coating above said substrate (1) and which comprises at least one main layer (3) of titanium and silicon nitride (Ti, Siₖ)Nₓ or of titanium and silicon nitride doped with oxygen (Ti, Siₖ)NₓO_{y}, and further **characterised in that** said component comprises an additional intermediate layer (2) and/or an additional upper layer (4), transparent or semi-transparent, between the substrate (1) and the main layer (3) of titanium and silicon nitride (Ti, Siₖ)Nₓ or of titanium and silicon nitride doped with oxygen (Ti, Siₖ)NₓO_{y}, and/or on the free surface of the main layer (3) of titanium and silicon nitride (Ti, Siₖ)Nₓ or of titanium and silicon nitride doped with oxygen (Ti, Siₖ)NₓO_{y}, and **in that**, in order to protect said component from discolouration in a warm or/and humid environment, said additional layer (2, 4) comprises a stack of alumina Al₂O₃ layers alternating with at least one main layer of titanium and silicon nitride (Ti, Siₖ)Nₓ or of titanium and silicon nitride doped with oxygen (Ti, Siₖ)NₓO_{y}.

16. Watchmaking or jewellery casing part component according to claim 15, **characterised in that** said substrate (1) is a dial.
